# EUROPEAN PATENT APPLICATION

(11) **EP 4 801 213 A1**
(43) Date of publication of application: **02.09.2026**
(21) Application number: 26159146.5
(22) Date of filing: 17.02.2026
(51) Int. Cl.: H05K 7/20

(54) **COOLING SYSTEM FOR ELECTRONIC DEVICES**

(30) Priority: 28.02.2025 US 202563764609 P
(71) Applicant: Karl Storz SE & Co. KG, 78532 Tuttlingen (DE)
(72) Inventor: Roth, Jeremy, Goleta, 93117 (US); Anhalt, Thomas J., Goleta, 93117 (US); Sanandajifar, Joseph, Goleta, 93117 (US); de Goede, Grant, Goleta, 93117 (US)

(57) **Abstract**

The present disclosure is generally related to a cooling system for an electronic device. Some electrical devices benefit from having foam inside an outer metal enclosure/chassis to hold the various components. The foam can assist with one or more of airflow, device mounting, noise dampening and shock absorption. However, one challenge that exists is that foam can present challenges for heat dissipation from the various electronic components. One exemplary aspect is directed to a fan-based cooling system for electronic devices that are mounted in a foam support structure. Another exemplary aspect is directed to a fan-based cooling system for electronic medical devices that are mounted in a foam support structure. Yet another exemplary aspect is directed to a fan-per-component group solution for cooling an electronic device.

## Description

### CROSS-REFERENCE TO RELATED APPLICATIONS

The present application refers to a cooling system for an electronic equipment, particularly a cooling system for an electronic equipment comprising several electronic components, for example circuit boards, especially a cooling system for an electronic equipment of a medical device.

### BACKGROUND

The present disclosure is generally related to a cooling system for an electronic device.

An example for an air-cooled electronic system is disclosed in US 6,525,936 B2. The system comprises an enclosure accommodating various electronic components and simultaneously providing different levels of cooling in response to the individual cooling needs of the various electronic components.

Some electrical devices benefit from having foam inside an outer metal enclosure to hold the various components. For example, US 5,214,572 A shows an electronic cage for housing electronic components like circuit boards and power supplies therein. The cage includes a box-like receiving area for supporting the components. The receiving area is defined by a plurality of upstanding side walls and a floor member. The cage is a one-piece construction of injection molded structural foam. In general, the foam can assist with one or more of airflow, device mounting, noise dampening and shock absorption. However, one challenge that exists is that foam can present challenges for heat dissipation from the various electronic components.

### SUMMARY

The present disclosure is generally directed to an improved cooling system for an electronic device and/or electronic equipment as defined in claim 1. Embodiments of the cooling system are disclosed in the depending claims.

The cooling system for electronic equipment comprises at least one molded foam support element having one or more recesses configured to hold a blower, a controller connected to the blower and associated with an electronic component of the electronic equipment and configured to control an airflow rate of the blower, and one or more air ducts formed into the at least one foam support element configured for directing air flow. Thus, the at least one molded foam support element serves as a multi-functional element, which allows for efficient use of given space, individual accommodation of electronic components and blowers, and customized air flow.

In one example embodiment, the cooling system for electronic equipment comprises a plurality of foam support elements, wherein at least one of the plurality of foam support elements comprises a blower recess and a blower that is secured within the blower recess. Further, the cooling system comprises a controller, which is connected to the blower and associated with an electronic component of the electronic equipment, and is configured to control an airflow rate of the blower based on a temperature of the component. Furthermore, the cooling system comprises one or more interconnected air ducts formed through the plurality of foam support elements. The plurality of foam support elements allows for simple assembly of the cooling system and provides easy access to areas of the electronic equipment.

In one example, the cooling system further comprises at least one additional molded foam support element, the at least one molded foam support element interlocking with the at least one additional foam support element. Advantageously, the plurality of foam support elements interlock with each other. For example, the plurality of foam support elements are keyed.

In a further example, one of the one or more air ducts passes through two or more molded foam support elements. For example, at least one of the plurality of foam support elements includes an air inlet port and an air outlet port. As such, the at least one molded foam support element may include air conduct portions for directing airflow. An air duct of one molded foam support element may merge into an air duct of another molded foam support element and define a common air duct through the electronic equipment. In an example, the cooling air for one component is directed to cool another component. This may be used, when a temperature of a subsequent electronic component is still higher than the cooling air flow leaving a previous electronic component.

The cooling system may comprise a plurality of blowers and a corresponding plurality of associated controllers. Advantageously, there is a dedicated blower and controller for certain components within the electrical equipment. Further, there may be a blower and a controller for each component. Thus, each blower of the plurality of blowers may have an airflow rate that is individually controlled. The airflow rate of the blowers, for example is controlled by changing a speed of fan blades of the blower The cooling of the electronic equipment can be optimized and noise can be reduced.

In a further example of the cooling system the molded foam support element may include sound dampening. The sound dampening assists in reducing the noise created by the blowers in the electronic equipment.

In a still further example of the cooling system, the at least one molded foam support element fits within a chassis. Advantageously, the plurality of foam support elements fill an enclosure of the electronic equipment, like the chassis of the equipment. Thus, areas within the electronic equipment that are not occupied by any other components can substantially be filled by the foam support elements.

In a still further example of the cooling system the at least one molded foam support element includes cable channels. The cable channels are arranged such that the electronic components can be connected to a power supply. Also, the controller can be located on the electronic component. Thus, the existing space within the electronic equipment is used efficiently.

In yet a further example of the cooling system the plurality of foam support elements are configured to hold one or more electronic components. For example, the foam support elements may comprise recess, slits, press fits or other structures for supporting parts of the electronic components, particular edge parts thereof.

The foam support elements may be molded to accommodate a plurality of blowers and an associated plurality of electronic components. The casting molds for producing the foam support elements may be easily adjusted to the form and size of the electronic equipment, the blowers and the required air duct.

In summary the cooling system for electronic equipment of the present invention may comprise the following aspects.

One exemplary aspect is directed to a fan-based cooling system for electronic devices that are mounted in a foam support structure.

One exemplary aspect is directed to a fan-based cooling system for electronic medical devices that are mounted in a foam support structure.

Another exemplary aspect is directed to a fan-per-component group solution for cooling the electronic device/equipment.

Another exemplary aspect is directed to providing ducting in a foam support enclosure to guide airflow for the electronic device.

Another exemplary aspect is directed to keyed, interlocking foam blocks with ducting therethrough to assist with electronic device cooling.

Yet another exemplary aspect is directed to dedicated fan controls for components within the electrical device.

Yet another exemplary aspect provides dedicated adaptive blowers for certain components.

Further exemplary aspects provide a PCB mount system to suspend a PCB between a PCB clip(s) and/or PCB stand-offs in support slots and a card edge connector on another board, such as a motherboard, with dedicated cooling channels in between.

Further exemplary aspects provide a PCB mount system to suspend a PCB between a PCB clip(s) and/or PCB stand-offs in support slots and a card edge connector on another board, such as a motherboard while reducing PCB-to-support structure contact and providing dedicated cooling channels and blowers.

Further exemplary aspects provide a PCB mount system to suspend a PCB between a PCB clip and/or stand-offs in support slots and a card edge connector on another board, such as a motherboard, such that the PCB floats with ducting formed in the mounting foam.

Further exemplary aspects provide a PCB mount system to suspend a PCB between a PCB stand-off and a card edge connector on another board, such as a motherboard, such that the PCB floats and blowers are placed into recesses within the foam support structure.

Other exemplary aspects provide a PCB mounting system that improves spacing and airflow around a PCB using specifically molded interlocking and/or keyed foam supports.

Additional exemplary aspects provide a system that helps protect electronic components from shock loads and movement.

Further aspects relate to camera control units that can get hot, and fans to cool them can be loud and cause wear on components. Specific pathways for air draw for cooling coupled with foam usage to retain boards addresses these problems, and with air being drawn from one (or more) side to the rear, rather than blown from the rear to the rear or from the rear to the side, this helps with cooling, noise and wear.

Aspects are also directed to a layout optimized for assembly, damping, air circulation, and easy assembly, and an air flow system and heat sink structure configured to suck in air from the side, and emit hot air from the back. A single air channel can be provided for each board, with each board optionally having its own blower. A modular set up allows for stacking boards on top of each other, with independent cooling for each board by radial blower. A gap between the front panel and the vertical board(s) can be provided to compensate for tolerances of parts. In one exemplary embodiment, the material is produced with smaller beads than usual, which helps with one or more of manufacturing, small corner/edge design, noise cancelling, structural strength, and heat control. This design also facilitates a design with no screws retaining the PCB boards. And noise can be limited based on the necessary power consumption.

The preceding is a simplified summary of the disclosure to provide an understanding of some aspects of the disclosure. This summary is neither an extensive nor exhaustive overview of the disclosure and its various aspects, embodiments, and configurations. It is intended neither to identify key or critical elements of the disclosure nor to delineate the scope of the disclosure but to present selected concepts of the disclosure in a simplified form as an introduction to the more detailed description presented below. As will be appreciated, other aspects, embodiments, and configurations of the disclosure are possible utilizing, alone or in combination, one or more of the features set forth above or described in detail below.

Numerous additional features and advantages are described herein and will be apparent to those skilled in the art upon consideration of the following Detailed Description and in view of the accompanying figures.

### BRIEF DESCRIPTION OF THE DRAWINGS

The accompanying drawings are incorporated into and form a part of the specification to illustrate several examples of the present disclosure. These drawings, together with the description, illustrate exemplary principles of the disclosure. The drawings simply illustrate exemplary and alternative examples of how the disclosure can be made and used and are not to be construed as limiting the disclosure to only the illustrated and described examples. Further features and advantages will become apparent from the following, more detailed, description of the various aspects, embodiments, and configurations of the disclosure, as illustrated by the drawings referenced below.

It should be understood that the drawings are not necessarily to scale. In certain instances, details that are not necessary for an understanding of the disclosure or that render other details difficult to perceive may have been omitted. It should be understood, of course, that the disclosure is not necessarily limited to the particular embodiments illustrated herein.
Fig. 1 illustrates a perspective view of an exemplary mounting block system and cooling components in accordance with aspects of the present disclosure.
Fig. 2 illustrates a perspective view of an exemplary mounting block system and cooling components indicating airflow in accordance with aspects of the present disclosure.
Fig. 3 illustrates a perspective view of an exemplary mounting block system and cooling cutouts in accordance with aspects of the present disclosure.
Fig. 4 illustrates a top perspective view of an exemplary electronic device with the mounting block system and cooling components in accordance with aspects of the present disclosure.
Fig. 5 illustrates another top perspective view of an exemplary electronic device with the mounting block system and cooling components in accordance with aspects of the present disclosure.
Fig. 6 illustrates a side view of the CPU cooling components in accordance with aspects of the present disclosure.
Fig. 7 illustrates another side view of the CPU cooling components in accordance with aspects of the present disclosure.
Fig. 8 illustrates another side view of the CPU cooling components in accordance with aspects of the present disclosure.
Fig. 9 illustrates a side perspective view of the CPU mounting blocks in accordance with aspects of the present disclosure.
Fig. 10 illustrates an exemplary blower and air ducting system for the CPU and associated heatsink in accordance with aspects of the present disclosure.
Fig. 11 illustrates an exemplary blower and air ducting system for the CPU and associated heatsink in accordance with aspects of the present disclosure.

### DETAILED DESCRIPTION

Before any embodiments of the disclosure are explained in detail, it is to be understood that the disclosure is not limited in its application to the details of construction and the arrangement of components set forth in the following description or illustrated in the drawings. The disclosure is capable of other embodiments and of being practiced or of being carried out in various ways. Also, it is to be understood that the phraseology and terminology used herein is for the purpose of description and should not be regarded as limiting. The use of "including," "comprising," or "having" and variations thereof herein is meant to encompass the items listed thereafter and equivalents thereof as well as additional items. Further, the present disclosure may use examples to illustrate one or more aspects thereof. Unless explicitly stated otherwise, the use or listing of one or more examples (which may be denoted by "for example," "by way of example," "e.g.," "such as," or similar language) is not intended to and does not limit the scope of the present disclosure.

The ensuing description provides embodiments only, and is not intended to limit the scope, applicability, or configuration of the claims. Rather, the ensuing description will provide those skilled in the art with an enabling description for implementing the described embodiments. It being understood that various changes may be made in the function and arrangement of elements without departing from the spirit and scope of the appended claims.

Various aspects of the present disclosure will be described herein with reference to drawings that may be schematic illustrations of idealized configurations.

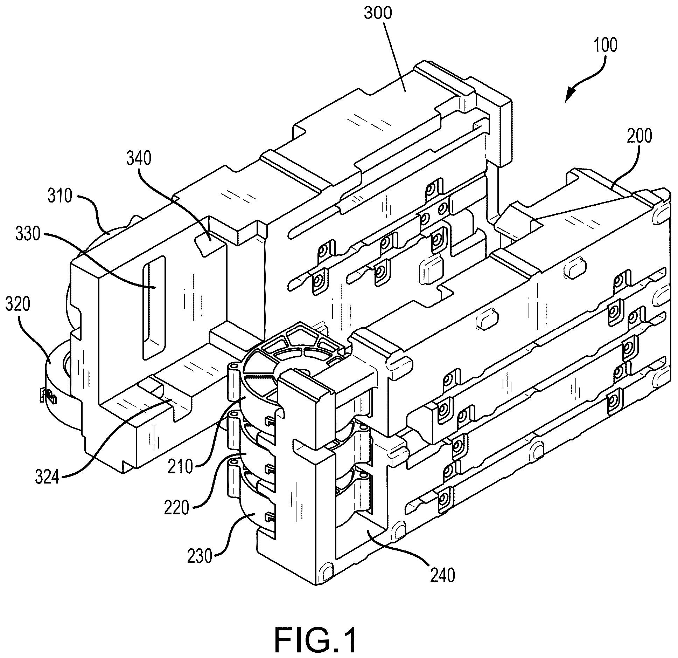

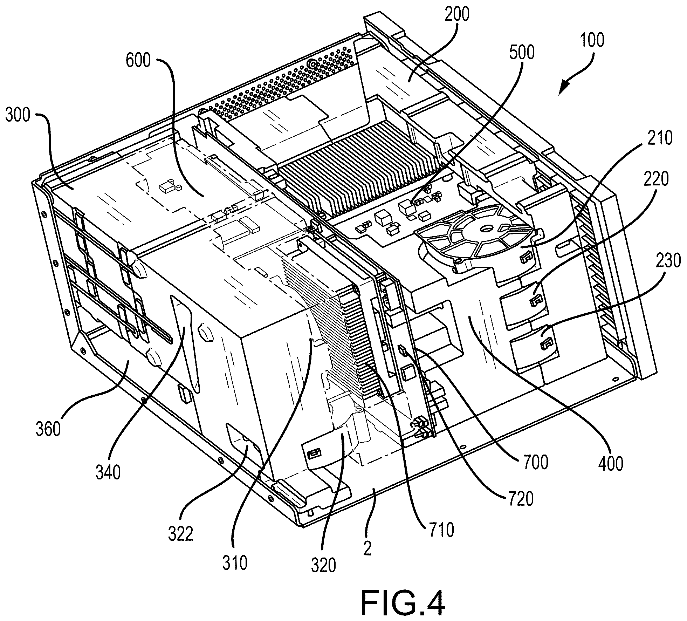

Fig. 1 illustrates perspective views of a cooling system, which serves as an exemplary mounting block system, and cooling components in accordance with aspects of the present disclosure. For context, Figs. 4-5 show a partially assembled exemplary system that utilizes the various components discussed herein. This exemplary system can be realized in a medical device, designated by reference number 100, and can include one or more printed circuit boards (PCBs) 500, such as graphics cards, motherboard(s), power supplies, etc. The PCBs for example represent electronic components as discussed before or may carry such electronic components. One or more of the components therein can also have an associated heat sink(s), for example heatsink 710 shown in Fig. 4, with any one or more of these devices having a need for cooling.

One exemplary method of securing the various components in a chassis 2 is to use foam inserts in form of molded foam support elements 200, 300, etc. These foam inserts/supports can be custom formed to accommodate the various components within the device. According to one exemplary embodiment, the customization of these foam inserts/support elements also allows airflow channels to be formed therein to supply cool air to one or more of: one or more blowers, and one or more electronic components of the system. These airflow channels can be formed through one or more of the foam inserts/supports, and since the foam inserts/supports can be interlocking and/or keyed and fitted adjacent to one another, they provide a substantially sealed pathway for the air to flow to the various blowers/components. The foam inserts/supports can also include one or more portions or air ducts that direct air to a specific component or area of a component, such as a heatsink, that further facilitates cooling.

In Fig. 1, two of the exemplary foam inserts/support elements are shown for the device 100 as foam support element 200 and foam support element 300. Exemplary foam support 200 supports a plurality of PCBs (not shown) and a corresponding plurality of blowers 210, 220 and 230.

Foam support 300 also supports various electronic components and includes two exemplary blowers 310 and 320. It is to be appreciated that while five blowers are shown, any number of blowers can be included for the device 100.

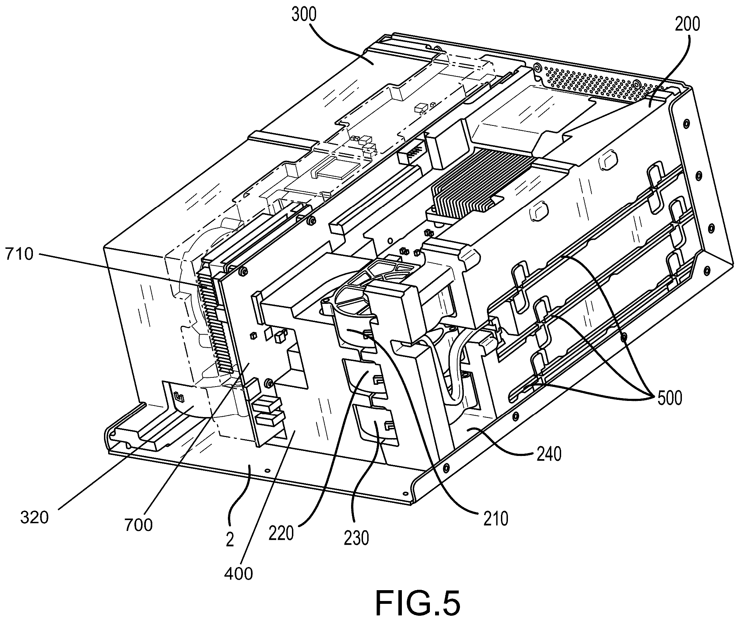

As discussed, one or more air ducts can be formed in the foam support elements, with in Fig. 1 a portion of air duct 340 seen as well as a portion of air duct 324 and air duct 240. As discussed hereinafter, the air ducts can supply air to/from the various electronic components and facilitate airflow within the device 100. Foam support 200 is also shown with an exemplary air duct 240 to cool the PCBs, not shown in this figure, but can be seen at least in Fig. 5.

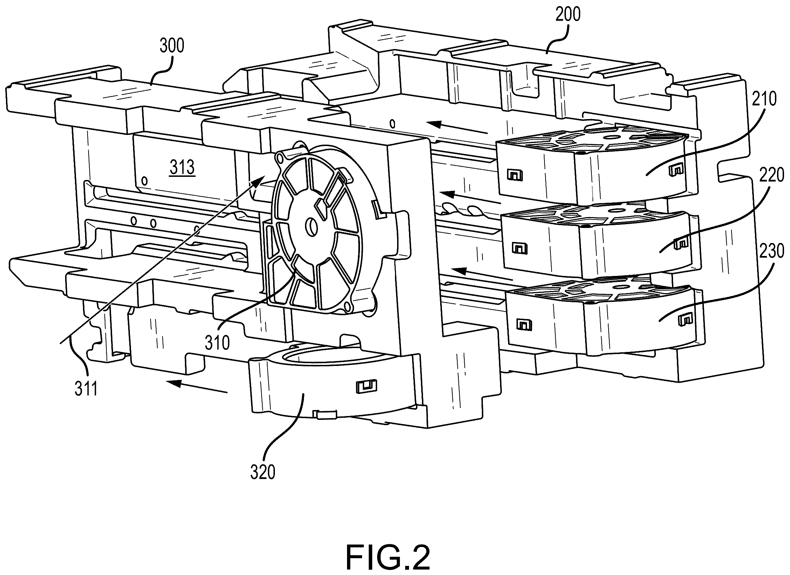

Fig. 2 illustrate perspective views of an exemplary mounting block for a cooling system and cooling components from the left-hand side of the device 100 in accordance with aspects of the present disclosure. Also labeled in this figure are exemplary airflow diagrams illustrating where the various blowers are directing the cooling air. Of note, and as can be more clearly visualized in other figures, blower 310 pulls air via airflow path 311 in through air duct 340 which then passes over a heatsink and is exhausted over one or more electronic components generally installed in area 313 out of the rear of device 100.

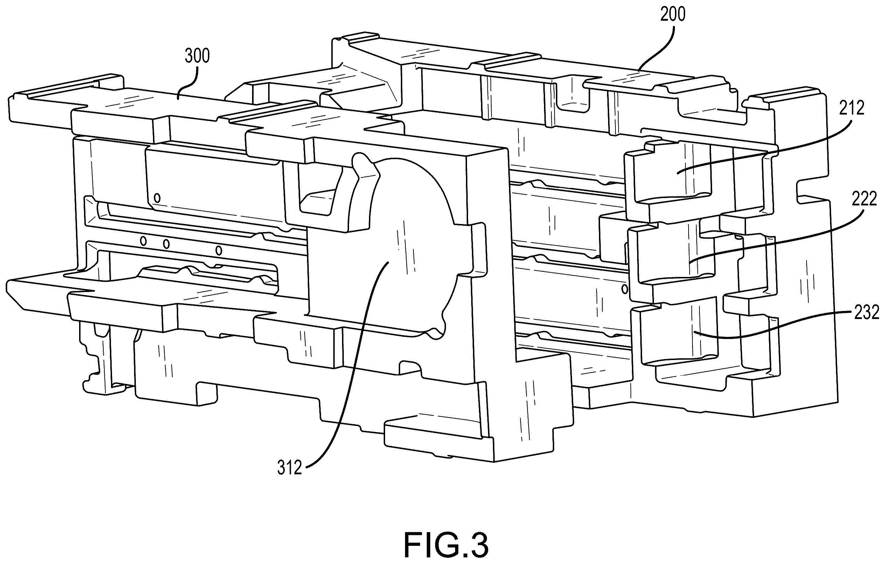

Fig. 3 illustrates a perspective view of an exemplary mounting block for a cooling system and cooling cutouts in accordance with aspects of the present disclosure. Recesses 312, 212, 222 and 232 are shown that are formed in the foam support elements 300 and 200 to hold the various blowers. While a certain orientation and recess shape is shown, it is to be appreciated that the size, shape, location and number of these recesses can be varied based on the specific implementation.

Fig. 4 illustrates a top perspective view of an exemplary electronic device 100 with the mounting block system and cooling components in accordance with aspects of the present disclosure.

Foam support element 200 and foam support element 300 are shown installed in the chassis 2, as well as foam support element 400. Exemplary foam supports 200 and 400 support a plurality of PCBs 500 and the corresponding plurality of blowers 210, 220 and 230. Exemplary foam supports 200 and 400 also partially support the main board or motherboard 700. As will be discussed hereinafter, for each of the various electronic components that has an associated blower, there is a dedicated blower control 720 that controls the blower speed based on a measured temperature of the electronic component.

Foam support element 300 also supports various electronic components 600 and includes two exemplary blowers 310 and 320. Blower 310 is for heatsink 710, and blower 320 is for the power supply 325 (not shown) located in space 360. Fresh air coming in through air duct 340 is passed over heatsink 710, sucked therethrough, and directed to and exhausted over components 600 and expelled out the back of the device 100. Even though this air was already used to cool the heatsink 710 associated with the motherboard 700, it still provides sufficient cooling to cool components 600.

Cooling efficiencies can be improved by having individually controlled blowers and blower controllers. This at least provides more customized heat dissipation for specific components/boards within the device 100. For example, there can be a blower controller installed on each of the PCBs 500 to control the associated blower. In this exemplary embodiment, there are three PCBs supported by the foam support elements 200 and 400, each with a corresponding dedicated blower 210-230. Each of the blowers 210-230 have a corresponding dedicated blower controller located on the corresponding PCB that measures a temperature of the PCB and adjusts the blower speed accordingly.

For example, the first PCB has a first thermometer and first blower controller to control first blower 210. The second PCB has a second thermometer and second blower controller to control the second blower 220. The third PCB has a third thermometer and third blower controller to control the third blower 230.

The blower 310 can be controlled by another thermometer and blower controller 720 located on the main or motherboard 700. The power supply can similarly control blower 320 with its own blower controller.

Having multiple blowers and blower controllers also helps with noise control as the airflow rate, respectively the speed, of each individual blower is regulated, as opposed to one blower running at a corresponding airflow rate to cool the hottest component in a device, regardless of the temperature of other components within the device.

Fig. 5 illustrates another top perspective view of an exemplary device 100 with the cooling system and cooling components in accordance with aspects of the present disclosure. The air inlet 240 supplies the various blowers 210-230 used to cool the PCBs 500. Support element 200 supports the PCBs 500 and support element 300 supports the various components on the other side of the device 100.

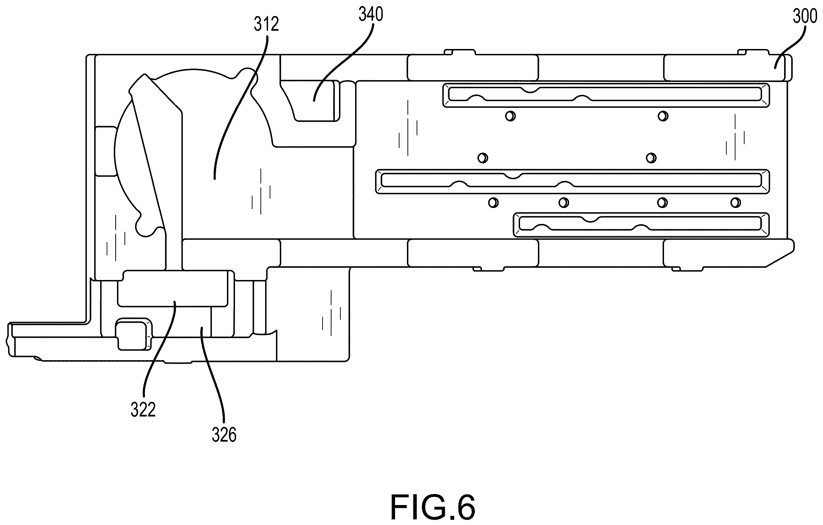

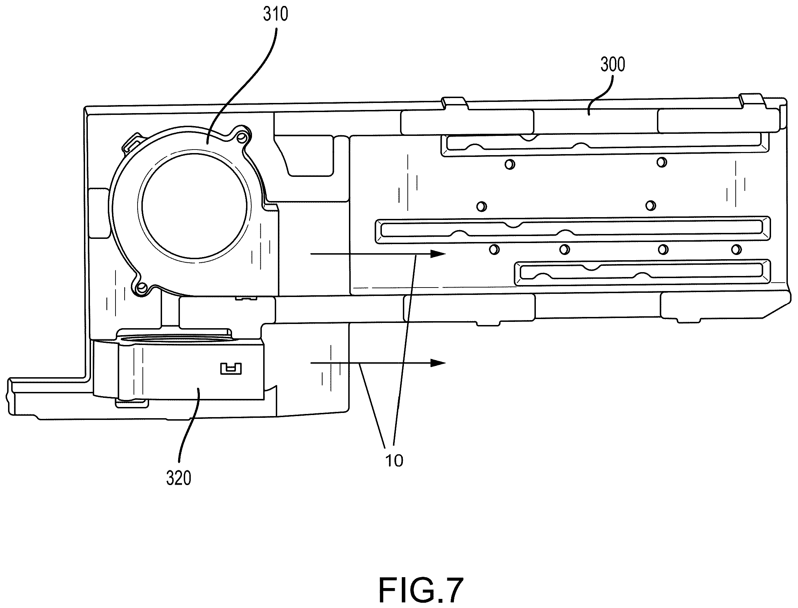

Specifically, Figs. 6-7 illustrate side views of the cooling system components in accordance with aspects of the present disclosure. Foam support element 300 includes blower recesses 312 and 326 (as shown in Fig. 6), that accommodate blowers 310 and 320 (as shown in Fig. 7), respectively. Airflow from the blowers 310 and 320 is illustrated by bold airflow arrows 10 in Fig. 7. An inner side of air ducts 340 and 322 in the foam support element 300 supply the blowers 310 and 320, respectively.

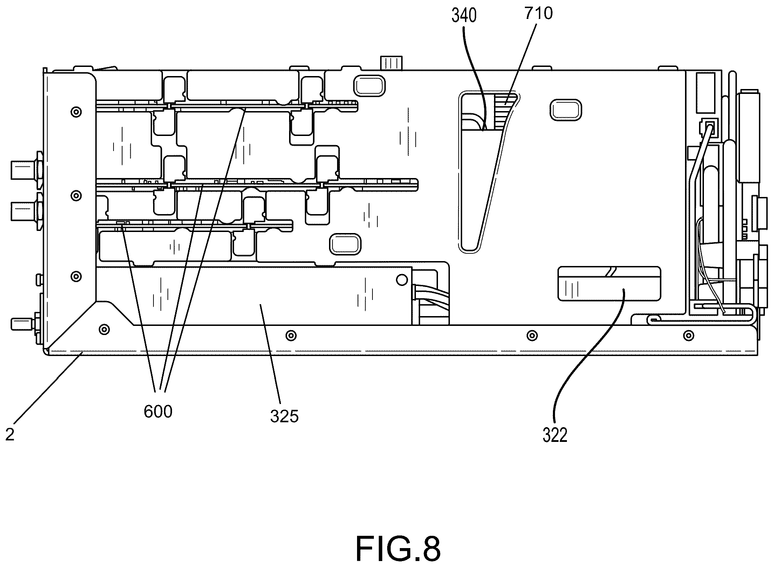

Fig. 8 illustrates another side view of the cooling system components in accordance with aspects of the present disclosure. Again, air ducts 340 and 322 are shown with many of the remaining components of device 100. The heatsink 710 for the CPU 700 can be seen through the air duct 340, and the power supply 325 cooled by blower 322 is also visible.

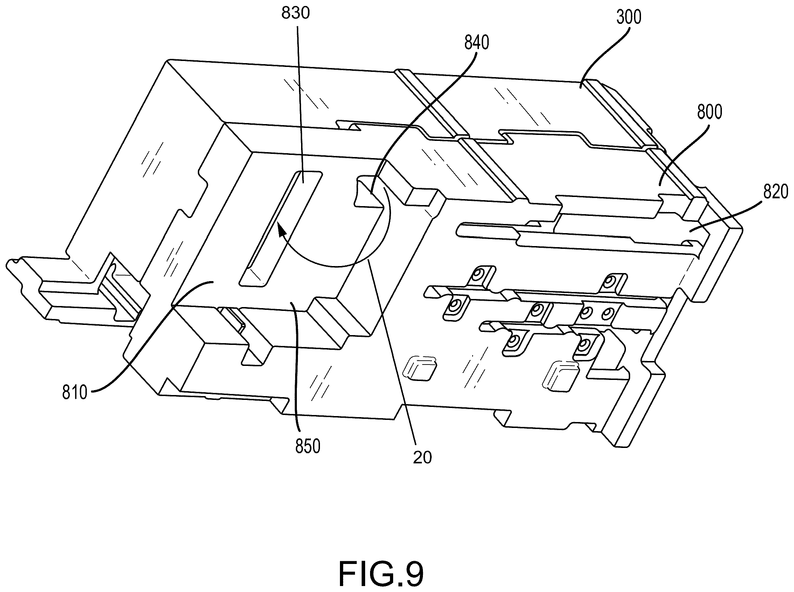

Fig. 9 shows an additional molded foam support element 800. Foam support element 800 adjoins support element 300 and interconnects various air ports to supply the main board and in this particular exemplary embodiment, the CPU(s) 600 and 700. Fig. 9 illustrates a side perspective view of the CPU mounting provided by foam support elements 300 and 800 in accordance with aspects of the present disclosure. Airflow through air ducts 340 and 840 supply the cooling for the CPU 700 with air entering through connected air ducts 340 and 840, the air being sucked across a CPU heatsink 710 (seen in Fig. 4) and entering air duct 830 in foam support element 800, as indicated by arrow 20. The air flows along the air channel between foam support elements 300 and 800, as indicated by arrows 10 in Fig. 7, and is exhausted out the rear 820 of the device 100. The heatsink 710 is accommodated in recess 850 such that air enters from the side of the heatsink, is redirected to the electronic components 600 and exits as shown. Thus, cooling air for the electronic component in form of CPU 700 is directed to cool the other electronic component 600.

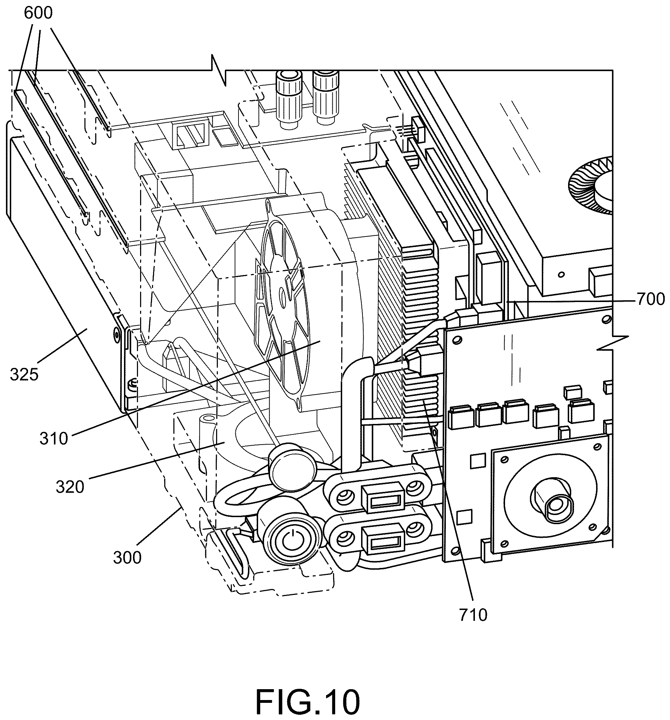

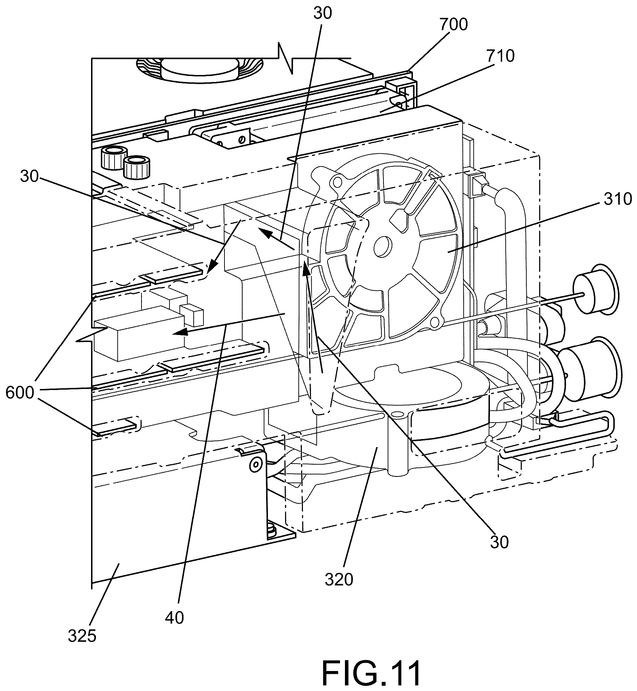

Figs. 10 and 11 illustrate exemplary blower and air ducting for the CPU 700 and associated heatsink 710 in accordance with aspects of the present disclosure. Specifically, Fig. 10 shows the arrangement of the blower 320 relative to the heatsink 710, and the associated ducting that allows cool air to be pulled from the side of the enclosure, respectively the chassis 2, drawn around and through the heatsink 710, then the heated air exhausted toward the rear exhaust 820 of the device 100. Fig. 11 shows this airflow in greater detail with the arrows 30 indicating the cool inlet air, and the arrow 40 indicating the warmer exhaust air exiting the heatsink 710.

As discussed, the cool inlet air passes through air ducts in the molded foam support elements, and the cooling air, after being pulled through the heatsink 710, exhausted over, for example, PCBs 600 toward the rear of the device 100, optionally through an exhaust tunnel in the molded foam support elements.

Any of the steps, functions, and operations discussed herein can be performed continuously and/or automatically.

While the steps have been discussed and illustrated in relation to a particular sequence of events, it should be appreciated that changes, additions, and omissions to this sequence can occur without materially affecting the operation of the disclosed embodiments, configuration, and aspects.

Although the figures are largely shown in solid lines, it should be understood that one or more aspects may not form part of the claimed invention or design but rather is only a portion of an environment surrounding the claimed invention or design and/or a portion of an environment in which the claimed invention or design operates. In one non-limiting example, any or all of the various components may or may not form part of the claimed invention or design but rather is only a portion of an environment surrounding the claimed invention or design and/or a portion of an environment in which the claimed invention or design operates. Therefore, the description through the present disclosure should not be interpreted as a limitation on the scope of the present disclosure but merely an illustration.

The exemplary systems and methods of this disclosure have been described in relation to an electronics cooling system. However, to avoid unnecessarily obscuring the present disclosure, the preceding description may omit a number of known structures and devices. For example, the Figures show components of electrical connections, electronic components for operating the device 100, operating components for manual input/output, wiring and assembling means. Their omission is not to be construed as a limitation of the scope of the claimed disclosure. Specific details are set forth to provide an understanding of the present disclosure. It should, however, be appreciated that the present disclosure may be practiced in a variety of ways beyond the specific detail set forth herein.

A number of variations and modifications of the disclosure can be used. It would be possible to provide for some features of the disclosure without providing others. In addition, it would be possible to combine some features of the disclosure without combining all.

References in the specification to "an aspect," "one embodiment," "an embodiment," "an example embodiment," "some embodiments," etc., indicate that the embodiment described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in conjunction with one embodiment, it is submitted that the description of such feature, structure, or characteristic may apply to any other embodiment unless so stated and/or except as will be readily apparent to one skilled in the art from the description.

The foregoing discussion of the disclosure has been presented for purposes of illustration and description. The foregoing is not intended to limit the disclosure to the form or forms disclosed herein. In the foregoing Detailed Description for example, various features of the disclosure are grouped together in one or more embodiments, configurations, or aspects for the purpose of streamlining the disclosure. The features of the embodiments, configurations, or aspects of the disclosure may be combined in alternate embodiments, configurations, or aspects other than those discussed above.

Moreover, though the description of the disclosure has included description of one or more embodiments, configurations, or aspects and certain variations and modifications, other variations, combinations, and modifications are within the scope of the disclosure, e.g., as may be within the skill and knowledge of those in the art, after understanding the present disclosure.

It is to be appreciated that any feature described herein can be claimed in combination with any other feature(s) as described herein, regardless of whether the features come from the same described embodiment.
As used herein, the singular forms "a," "an," and "the" are intended to include the plural forms as well, unless the context clearly indicates otherwise. It will be further understood that the terms "include," "including," "includes," "comprise," "comprises," and/or "comprising," when used in this specification, specify the presence of stated features, integers, steps, operations, elements, and/or components, but do not preclude the presence or addition of one or more other features, integers, steps, operations, elements, components, and/or groups thereof. The term "and/or" includes any and all combinations of one or more of the associated listed items. The use of "including," "comprising," or "having" and variations thereof herein is meant to encompass the items listed thereafter and equivalents thereof as well as additional items. Accordingly, the terms "including," "comprising," or "having" and variations thereof can be used interchangeably herein.The phrases "at least one," "one or more," "or," and "and/or" are open-ended expressions that are both conjunctive and disjunctive in operation.

The term "automatic" and variations thereof, as used herein, refers to any process or operation, which is typically continuous or semi-continuous, done without material human input when the process or operation is performed. However, a process or operation can be automatic, even though performance of the process or operation uses material or immaterial human input, if the input is received before performance of the process or operation. Human input is deemed to be material if such input influences how the process or operation will be performed. Human input that consents to the performance of the process or operation is not deemed to be "material."

## Claims

1. Cooling system for electronic equipment comprising:
at least one molded foam support element (200; 300);
the at least one foam support element having one or more recesses (212; 222; 232; 312) configured to hold a blower (210; 220; 230; 310; 320);
a controller (720), connected to the blower and associated with an electronic component (600) of the electronic equipment, and configured to control an airflow rate of the blower (210; 220; 230; 310; 320); and
one or more air ducts (240; 324; 340) formed into the at least one foam support element (200; 300) configured for directing air flow.

2. Cooling system according to claim 1, further comprising at least one additional molded foam support element (800), the at least one molded foam support element (200; 300) interlocking with the at least one additional foam support element (800).

3. Cooling system according to claim 1 or 2, wherein one of the one or more air ducts (240; 324; 340) passes through two or more molded foam support elements (200; 300; 800).

4. Cooling system according to one of the previous claims, further comprising a plurality of blowers (210; 220; 230) and a corresponding plurality of associated controllers.

5. Cooling system according to one of the previous claims, wherein the at least one molded foam support element includes air duct portions for directing airflow.

6. Cooling system according to one of the previous claims, wherein the molded foam support element (200; 300) includes sound dampening.

7. Cooling system according to one of the previous claims, wherein the at least one molded foam support element includes cable channels.

8. Cooling system according to one of the previous claims comprising:
a plurality of foam support elements (200; 300; 400);
at least one of the plurality of foam support elements (200; 300; 400) having a blower recess (212; 222; 232; 312);
a blower (210; 220; 230; 310; 320) secured within the blower recess (212; 222; 232; 312); and
one or more interconnected air ducts (240; 324; 340) formed through the plurality of foam support elements (200; 300; 400).

9. The cooling system according to one of the previous claims, wherein the controller (720) is located on the electronic component.

10. Cooling system according to one of the previous claims, wherein there is a blower and a controller for each electronic component.

11. Cooling system according to one of claims 8 to 10, wherein the plurality of foam support elements (200; 300; 400) interlock.

12. The Cooling system according to one of claims 8 to 11, wherein the plurality of foam support elements (200; 300; 400) are configured to hold one or more electronic components (600).

13. Cooling system according to one of claims 8 to 12, wherein the plurality of foam support elements (200; 300; 400) substantially fill an enclosure for the electronic equipment.

14. Cooling system according to one of claims 8 to 13, wherein at least one of the plurality of foam support elements (200; 300; 400) includes an air inlet port (240) and an air outlet port.

15. Cooling system according to one of claims 8 to 14, wherein cooling air for one electronic component is directed to cool another electronic component.

16. Cooling system according to one of claims 8 to 15, wherein the foam support elements (200; 300; 400) are molded to accommodate a plurality of blowers (210; 220; 230) and an associated plurality of electronic components.
